# EUROPEAN PATENT APPLICATION

(11) **EP 4 722 757 A1**
(43) Date of publication of application: **08.04.2026**
(21) Application number: 25189780.7
(22) Date of filing: 16.07.2025
(51) Int. Cl.: G01S 7/484, G01S 17/894, G01S 7/481, G01S 7/497

(54) **OPTICAL DEVICE**

(30) Priority: 04.10.2024 JP 2024174845; 14.03.2025 JP 2025041933
(71) Applicant: FUJIFILM Business Innovation Corp., Minato-ku Tokyo (JP)
(72) Inventor: TAKEYAMA, Kei, Ebina-shi, Kanagawa (JP); HAYAKAWA, Junichiro, Ebina-shi, Kanagawa (JP); YAMAMOTO, Yoshihiro, Yokohama-shi, Kanagawa (JP)
(74) Representative: Becker Kurig & Partner Patentanwälte mbB

(57) **Abstract**

An optical device includes a light emitting unit (17) that has plural light emitting elements to irradiate, with light, each of plural divided regions (231-242) into which an irradiation region is divided and to emit the light with which an object is irradiated, a light receiving unit (18) that has plural light receiving elements to receive reflected light of the light with which the object is irradiated, and a light emission control unit that controls, in a region in which a light-receiving region of the reflected light in the object does not overlap with an irradiation region of the light with which the object is irradiated, light emission of the light with which the divided region, which is included in a target region (211) corresponding to the irradiation region, is irradiated.

## Description

### BACKGROUND OF THE INVENTION

### (i) Field of the Invention

The present invention relates to an optical device.

### (ii) Description of Related Art

A detection device consisting of a light emitting unit that includes a plurality of light emitting elements and is capable of independently driving the plurality of light emitting elements in a plurality of regions, and a light receiving unit that includes a plurality of light receiving elements receiving reflected light of light emitted from the light emitting unit toward an object is known (for example, refer to JP2023-113029A). In such a device, due to a difference in a disposition position of each of the light emitting unit and the light receiving unit, misalignment may occur between an irradiation region of the light with which the object is irradiated and a light-receiving region of the reflected light received by the light receiving unit.

### SUMMARY OF THE INVENTION

In a case where the misalignment occurs between the light-receiving region and the irradiation region, energy is wasted in a portion of the irradiation region that protrudes from the light-receiving region. Further, in a case where a light source that irradiates the irradiation region irradiates, with light, each divided region obtained by subdividing the irradiation region, a ratio (number or area) of the divided region affected by the misalignment varies depending on a position at which the misalignment between the light-receiving region and the irradiation region occurs and a shape of the divided region.

An object of the present invention is to suppress influence of misalignment, which is caused by a position at which the misalignment between a light-receiving region and an irradiation region occurs and a shape of a divided region.

According to a first aspect of the present disclosure, there is provided an optical device including a light emitting unit that has a plurality of light emitting elements to irradiate, with light, each of a plurality of divided regions into which an irradiation region is divided and to emit the light with which an object is irradiated, a light receiving unit that has a plurality of light receiving elements to receive reflected light of the light with which the object is irradiated, and a light emission control unit that controls, in a region in which a light-receiving region of the reflected light in the object does not overlap with an irradiation region of the light with which the object is irradiated, light emission of the light with which the divided region, which is included in a target region corresponding to the irradiation region, is irradiated.

According to a second aspect of the present disclosure, there is provided the optical device according to the first aspect, in which the light emission control unit may control the light emission of the light with which the divided region, which is included in the target region, is irradiated in a manner different from control of the light emission of the light with which the divided region, which is not included in the target region, is irradiated.

According to a third aspect of the present disclosure, there is provided the optical device according to the second aspect, in which the light emission control unit may turn off the light with which the divided region is irradiated, as the control of the light emission.

According to a fourth aspect of the present disclosure, there is provided the optical device according to any one of the first to third aspects, in which a shape of the divided region may be decided such that a ratio of a total area of the divided regions, which are included in the target region, to an area of the target region is increased.

According to a fifth aspect of the present disclosure, there is provided the optical device according to the fourth aspect, in which the shape of the divided region may be a rectangle, and the light emitting unit and the light receiving unit are disposed side by side in a direction of a short side of the rectangle.

According to a sixth aspect of the present disclosure, there is provided the optical device according to any one of the first to fifth aspects further including a detection unit that detects the target region, in which the light emission control unit may control the light emission of the light with which the detected target region is irradiated.

According to a seventh aspect of the present disclosure, there is provided the optical device according to the sixth aspect, in which the detection unit further may detect the divided region included in the detected target region, and the light emission control unit may control the light emission of the light with which the detected divided region is irradiated.

According to the first aspect of the present invention, influence of misalignment, which is caused by a position at which the misalignment between the light-receiving region and the irradiation region occurs and the shape of the divided region, can be suppressed.

According to the second aspect of the present invention, since the light emission is controlled for each divided region included in the target region, the influence of the misalignment caused by the shape of the divided region can be suppressed.

According to the third aspect of the present invention, since the light emitted toward the target region can be turned off, waste energy consumption can be suppressed.

According to the fourth aspect of the present invention, in a case where the area of the divided region included in the target region is increased, an area of the divided region that straddles the target region and the light-receiving region is relatively reduced. Therefore, the influence of the misalignment caused by the shape of the divided region can be suppressed.

According to the fifth aspect of the present invention, the divided region can be included in the target region without waste.

According to the sixth aspect of the present invention, there is no need for a person to visually determine the target region.

According to the seventh aspect of the present invention, there is no need for a person to visually determine the divided region.

### BRIEF DESCRIPTION OF THE DRAWINGS

Exemplary embodiment(s) of the present invention will be described in detail based on the following figures, wherein:
FIG. 1 is a diagram showing an example of an overall configuration of a TOF camera system including, as a component, a TOF camera device as an optical device to which the present exemplary embodiment is applied;
FIG. 2 is a diagram showing an example of a hardware configuration of the TOF camera device to which the present exemplary embodiment is applied;
FIG. 3 is a diagram showing an example of a functional configuration of a control unit of the TOF camera device;
FIG. 4 is a diagram showing a specific example of a target region and a divided region;
FIG. 5A is a diagram showing a specific example of a divided region included in the target region, which is detected by the TOF camera device and FIG. 5B is a diagram showing another specific example of the divided region;
FIGS. 6A and 6B are diagrams showing a specific example of a case where a light emitting unit and a light receiving unit of the TOF camera device are disposed side by side in an up-down direction; and
FIGS. 7A and 7B are diagrams showing a specific example of a case where a plurality of light emitting units of the TOF camera device are disposed.

### DETAILED DESCRIPTION OF THE INVENTION

Hereinafter, exemplary embodiments of the present invention will be described in detail with reference to accompanying drawings.

### <Configuration of TOF Camera System 1>

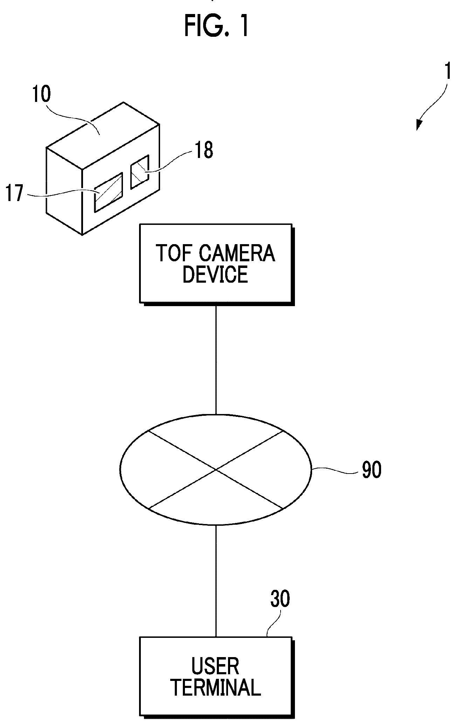

FIG. 1 is a diagram showing an example of an overall configuration of a TOF camera system 1 including, as a component, a TOF camera device 10 as an optical device to which the present exemplary embodiment is applied.

The TOF camera system 1 is configured by connecting the TOF camera device 10 and a user terminal 30 via a network 90. The network 90 is, for example, a local area network (LAN) or the Internet.

### [TOF Camera Device 10]

The time of flight (TOF) camera device 10 measures a flight time of light (for example, infrared light) to visualize a distance between the TOF camera device 10 and an object. The TOF camera device 10 includes a light emitting unit 17 that emits the light with which the object is irradiated, and a light receiving unit 18 that receives reflected light of the light of the light emitting unit 17 with which the object is irradiated. The TOF camera device 10 measures a time taken for the light emitted toward the object to return from the object and calculates a distance from the time to visualize the distance. While a normal camera can obtain only two-dimensional information of an object, the TOF camera device 10 can obtain three-dimensional information since the TOF camera device 10 includes information on a depth (direction toward object). Details of a configuration and processing of the TOF camera device 10 will be described below.

### [User Terminal 30]

The user terminal 30 is an information processing apparatus, such as a personal computer, a tablet terminal, or a smartphone, operated by a user using the TOF camera system 1. The user terminal 30 can execute an application program that makes the TOF camera system 1 usable. The user terminal 30 can acquire various types of information transmitted from the TOF camera device 10 and the outside to perform various types of processing. Further, the user terminal 30 can transmit various types of information to the TOF camera device 10 and the outside, and can cause the TOF camera device 10 to perform various types of processing.

The configuration of the TOF camera system 1 is an example, and the TOF camera system 1 may have a function of causing the above processing to be realized as a whole. Thus, a part or all of functions for causing the above processing to be realized may be shared or cooperated in the TOF camera system 1. That is, a part or all of the functions of the TOF camera device 10 configuring the TOF camera system 1 may be used as functions of another information processing apparatus (for example, user terminal 30), or a part or all of the functions of another information processing apparatus may be used as the functions of the TOF camera device 10. Further, a part or all of functions of each of the devices, such as the TOF camera device 10, configuring the TOF camera system 1 may be transferred to another server (not shown) or the like. Accordingly, the processing of the TOF camera system 1 as a whole is promoted, and the pieces of processing can be complemented.

### <Hardware Configuration>

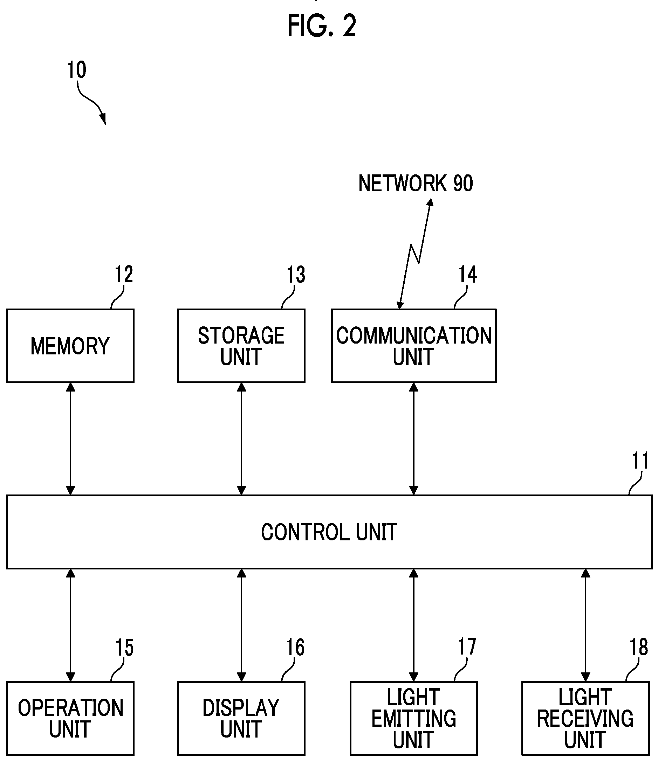

FIG. 2 is a diagram showing an example of a hardware configuration of the TOF camera device 10 to which the present exemplary embodiment is applied.

The TOF camera device 10 includes a control unit 11, a memory 12, a storage unit 13, a communication unit 14, an operation unit 15, a display unit 16, the light emitting unit 17, and the light receiving unit 18. The above units are connected to each other via a data bus, an address bus, a peripheral component interconnect (PCI) bus, or the like.

The control unit 11 is a processor that controls the functions of the TOF camera device 10 through execution of various types of software such as an OS (basic software) and application software.

In the exemplary embodiments, the processes are performed by any computer. The computer may perform the processes by using a processor serving as hardware, a program serving as software, or combination of these. In this case, the processor is configured to perform the processes in the exemplary embodiments in cooperation with the program and may function as a unit or a means in the exemplary embodiments. The order in which the processor performs the processes is not limited to the described order and may be changed appropriately. The computer may be a general-purpose computer, an application specific computer, a workstation, or another system capable of performing the processes.

The processor may be composed of one or more pieces of hardware, and the type of the hardware is not limited. For example, the processor may be composed of hardware such as a central processing unit (CPU), a micro processing unit (MPU), a programmable logic device such as a field programmable gate array (FPGA), a dedicated circuit for performing specific processing such as an application specific integrated circuit (ASIC), a graphics processing unit (GPU), or a neural processing unit (NPU).

Regarding the type of the hardware, different types of hardware may be combined. If multiple pieces of hardware are configured to perform one or more processes of the processor, the multiple pieces of hardware may be present in apparatuses physically away from each other or may be present in one apparatus. In each of exemplary embodiments, the order in which the processor performs the processes is not limited to the order described above and may be changed appropriately. The hardware is composed of electric circuitry in which circuit elements such as semiconductor devices are combined, or the like.

Further, the program may be software such as firmware or microcode. The program may be, for example, a program module group, and the functions thereof may be implemented by processors configured to implement the respective functions. The program may be program code or multiple code segments stored in one or more non-transitory computer readable media (for example, a storage medium or another storage). The program may be stored in such a divided manner in multiple non-transitory computer readable media present in apparatuses physically away from each other.

The program code or the code segments may represent a procedure, a function, a sub program, a routine, a subroutine, a module, a software package, a class or any combination of instructions, data structures, or program statements. The program code or the code segment may be connected to another code segment or a hardware circuit by transmitting and/or receiving information, data, an argument, a parameter, or memory content.

The memory 12 is a storage region in which various types of software, pieces of data used for executing the software, or the like are stored, and is used as a work area in calculations. The memory 12 is configured of, for example, a random access memory (RAM).

The storage unit 13 is a storage region in which input data for various types of software, output data from various types of software, or the like are stored. The storage unit 13 is configured of, for example, a hard disk drive (HDD), a solid state drive (SSD), or a semiconductor memory, which is used for storing a program, various types of setting data, or the like. The storage unit 13 is provided with a database that stores various types of information.

The communication unit 14 transmits and receives data to and from the user terminal 30 and the outside via the network 90. The operation unit 15 is configured of, for example, a keyboard, a mouse, a mechanical button, or a switch, and receives an input operation.

The operation unit 15 also includes a touch sensor integrally configuring a touch panel with the display unit 16.

The display unit 16 is configured of, for example, a liquid crystal display or an organic electro luminescence (EL) display, which is used for information display, and displays data of an image or a text and the like. The display unit 16 displays a user interface or the like.

The light emitting unit 17 has a plurality of light emitting elements to emit the light with which the object is irradiated. An irradiation region of the object irradiated with the light of the light emitting unit 17 is divided into a plurality of divided regions, and each divided region is irradiated with the light.

The light receiving unit 18 has a plurality of light receiving elements to receive reflected light of the light of the light emitting unit 17 with which the object is irradiated.

### <Functional Configuration>

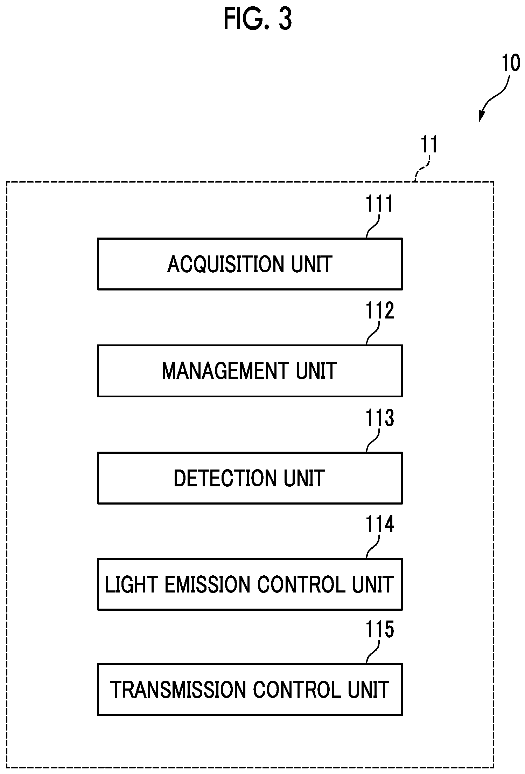

FIG. 3 is a diagram showing an example of a functional configuration of the control unit 11 of the TOF camera device 10.

In the control unit 11 of the TOF camera device 10, an acquisition unit 111, a management unit 112, a detection unit 113, a light emission control unit 114, and a transmission control unit 115 function.

The acquisition unit 111 acquires various types of information.

The management unit 112 stores and manages various types of information in the database of the storage unit 13 (refer to FIG. 2). For example, the management unit 112 stores and manages each piece of information, such as a measurement result of the distance to the object, in the database.

In a region in which a light-receiving region, in the object, of the reflected light of the light of the light emitting unit 17 with which the object is irradiated does not overlap with the irradiation region of the light of the light emitting unit 17 with which the object is irradiated, the detection unit 113 detects a region corresponding to the irradiation region (hereinafter referred to as "target region"). Further, the detection unit 113 detects a divided region included in the detected target region.

The light emission control unit 114 controls light emission of the light of the light emitting unit 17. For example, the light emission control unit 114 controls the light emission of the light with which the target region detected by the detection unit 113 is irradiated, as the control of the light emission of the light of the light emitting unit 17. Further, the light emission control unit 114 controls the light emission of the light with which the divided region included in the target region is irradiated. For example, the light emission control unit 114 controls the light emission of the light with which the divided region included in the target region is irradiated, unlike control of the light emission of the light with which a divided region not included in the target region is irradiated. Specifically, the light emission control unit 114 turns off the light with which the divided region is irradiated, as the control of the light emission of the light with which the divided region included in the target region is irradiated.

The transmission control unit 115 controls transmission of various types of information via the communication unit 14 (refer to FIG. 2). Specifically, the transmission control unit 115 controls transmission of various types of information to the user terminal 30. For example, the transmission control unit 115 controls transmission of the information, such as the measurement result of the distance to the object, to the user terminal 30.

### <Specific Example>

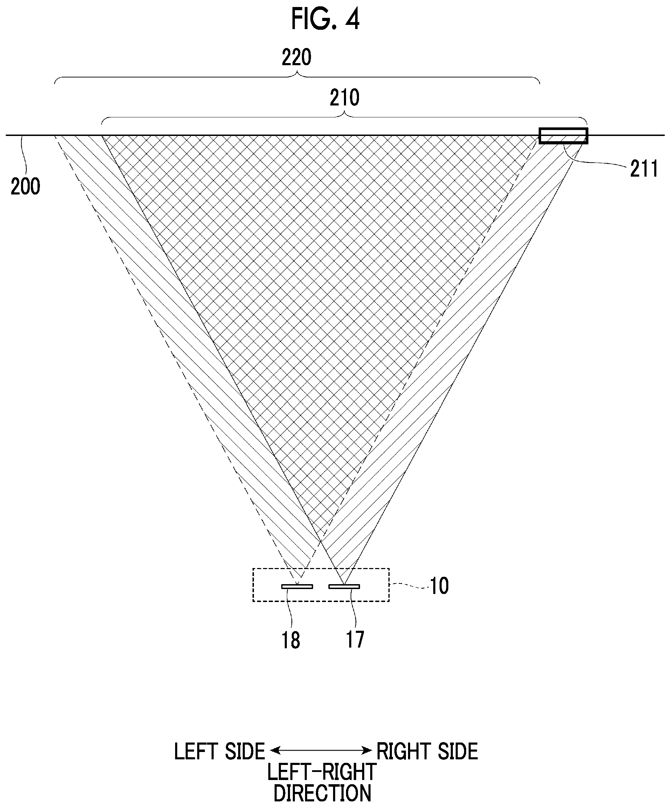

FIG. 4 is a diagram showing a specific example of the target region and the divided region.

FIG. 4 shows the TOF camera device 10 including the light emitting unit 17 that emits the light with which an object 200 is irradiated, and the light receiving unit 18 that receives the reflected light of the light of the light emitting unit 17 with which an object 200 is irradiated. Further, FIG. 4 shows an irradiation region 210 of the light of the light emitting unit 17 emitted from the TOF camera device 10 toward the object 200, and a light-receiving region 220, in the object 200, of the reflected light of the light thereof.

As shown in FIG. 4, a disposition position of the light emitting unit 17 of the TOF camera device 10 and a disposition position of the light receiving unit 18 thereof are misaligned in a right-left direction. For this reason, misalignment occurs between the irradiation region 210 of the light of the light emitting unit 17 with which the object 200 is irradiated and the light-receiving region 220 of the reflected light received by the light receiving unit 18. As a result, in the object 200, there are a region in which the irradiation region 210 overlaps with the light-receiving region 220 and a region in which the irradiation region 210 does not overlap with the light-receiving region 220, as shown in FIG. 4.

In the region in which the irradiation region 210 does not overlap with the light-receiving region 220, the detection unit 113 of the TOF camera device 10 detects a target region 211 corresponding to the irradiation region 210. The light with which the target region 211 is irradiated is not received by the light receiving unit 18 even in a case of being reflected by the object 200, and thus is a waste of energy.

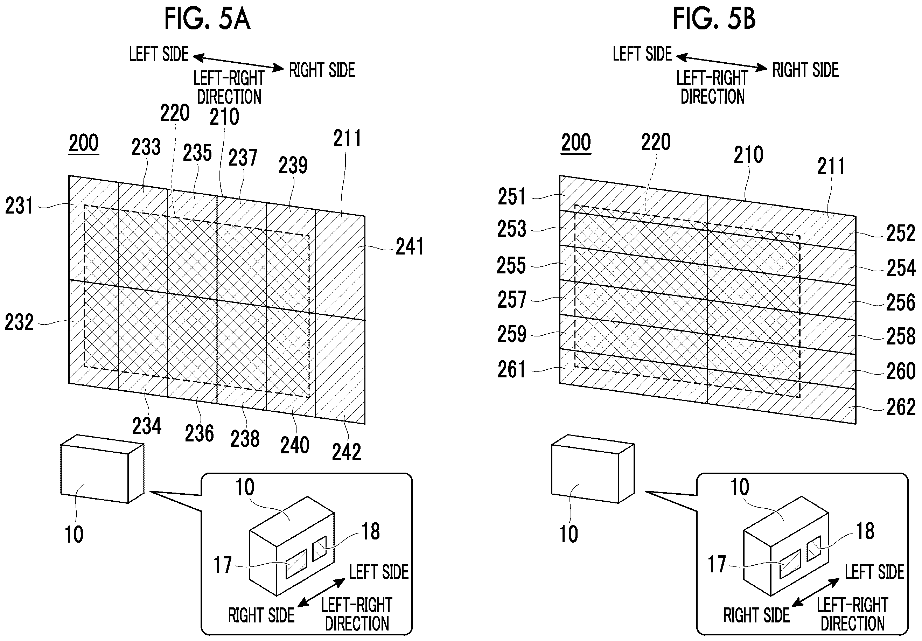

FIG. 5A is a diagram showing a specific example of the divided region included in the target region, which is detected by the TOF camera device 10. A surface of the TOF camera device 10 facing the object 200 (surface on which the light emitting unit 17 and the light receiving unit 18 are disposed) is shown in a speech bubble in FIG. 5A.

FIG. 5A shows a specific example of the divided region included in the target region 211, which is detected by the TOF camera device 10. The irradiation region 210 of the light emitted from the TOF camera device 10 toward the object 200 is divided into two rows and six columns, and thus is divided into a total of 12 rectangular divided regions 231 to 242.

Among the 12 divided regions 231 to 242, the divided regions 231 to 240 partially overlap with the light-receiving region 220, but the divided regions 241 and 242 do not overlap with the light-receiving region 220 and are included in the target region 211. Thus, the divided regions 241 and 242 are detected by the TOF camera device 10 as the divided regions included in the target region 211.

In a case where the divided regions 241 and 242 included in the target region 211 are detected, the TOF camera device 10 turns off the light with which the divided regions 241 and 242 are irradiated. Accordingly, only the divided regions 231 to 240 that partially overlap with the light-receiving region 220 are irradiated with the light, among the divided regions 231 to 242.

In the example shown in FIG. 5A, the light emitting unit 17 and the light receiving unit 18 of the TOF camera device 10 are disposed side by side in the right-left direction. In this case, the misalignment between the irradiation region 210 and the light-receiving region 220 is likely to increase in the right-left direction. For this reason, with shortening of a length of each of the divided regions 231 to 242 in the right-left direction, the divided regions to be turned off can be finely decided as compared with a case where the length thereof is long. Thus, a ratio of a total area of the divided regions to an area of the target region 211 can be increased.

On the contrary, a case will be described in which the length of the rectangular divided region in the right-left direction is longer than a length thereof in an up-down direction.

FIG. 5B is a diagram showing another specific example of the divided region. A surface of the TOF camera device 10 facing the object 200 (surface on which the light emitting unit 17 and the light receiving unit 18 are disposed) is shown in a speech bubble in FIG. 5B.

FIG. 5B shows an example of a case where the irradiation region 210 of the light emitted from the TOF camera device 10 toward the object 200 is divided into six rows and two columns, and thus is divided into a total of 12 rectangular divided regions 251 to 262. In the example of FIG. 5B, the length of the rectangle-shaped divided region in the right-left direction is longer than the length thereof in the up-down direction. In this case, since all of the divided regions 251 to 262 partially overlap with the light-receiving region 220, there is no divided region included in the target region 211. Therefore, there is no divided region for which the TOF camera device 10 is turned off.

In the examples of FIGS. 5A and 5B, since the light emitting unit 17 and the light receiving unit 18 of the TOF camera device 10 are disposed side by side in the right-left direction, the misalignment between the irradiation region 210 and the light-receiving region 220 is likely to increase in the right-left direction, as described above. However, the pattern of the disposition of the light emitting unit 17 and the light receiving unit 18 of the TOF camera device 10 is not limited thereto, and there are various patterns as described below.

### <Modification Example 1>

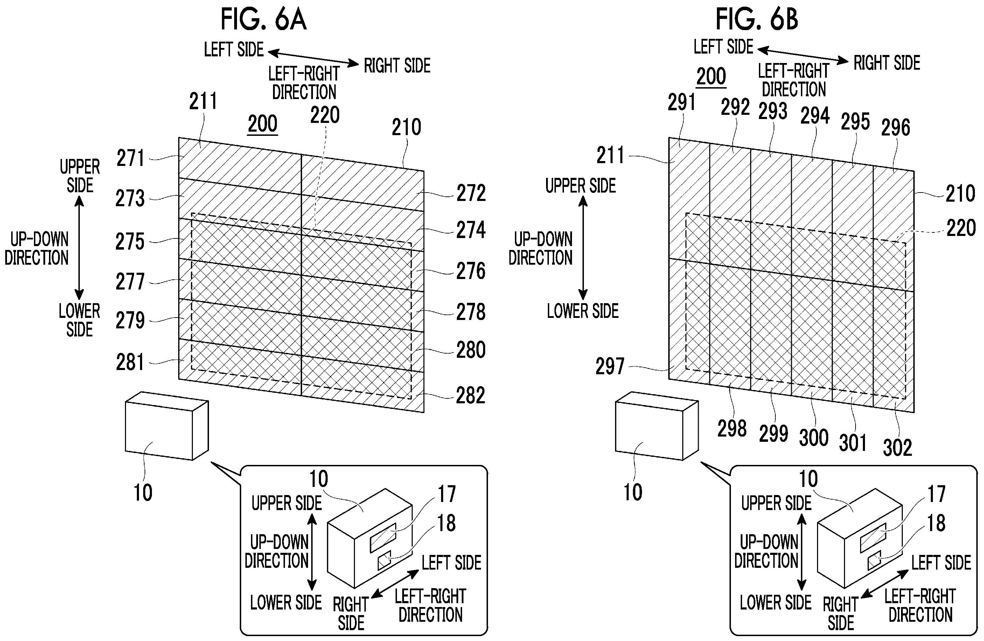

FIGS. 6A and 6B are diagrams showing a specific example of a case where the light emitting unit 17 and the light receiving unit 18 of the TOF camera device 10 are disposed side by side in an up-down direction. A surface of the TOF camera device 10 facing the object 200 (surface on which the light emitting unit 17 and the light receiving unit 18 are disposed) is shown in speech bubbles in FIGS. 6A and 6B.

FIG. 6A shows a specific example of the divided region included in the target region 211, which is detected by the TOF camera device 10. The irradiation region 210 of the light emitted from the TOF camera device 10 toward the object 200 is divided into six rows and two columns, and thus is divided into a total of 12 divided regions 271 to 282.

Among the divided regions 271 to 282, the divided regions 273 to 282 partially overlap with the light-receiving region 220, but the divided regions 271 and 272 do not overlap with the light-receiving region 220 and are included in the target region 211. Thus, the divided regions 271 and 272 are detected by the TOF camera device 10 as the divided regions included in the target region 211.

In a case where the divided regions 271 and 272 included in the target region 211 are detected, the TOF camera device 10 turns off the light with which the divided regions 271 and 272 are irradiated. Accordingly, only the divided regions 273 to 282 that partially overlap with the light-receiving region 220 are irradiated with the light, among the divided regions 271 to 282.

In the example shown in FIG. 6A, the light emitting unit 17 and the light receiving unit 18 of the TOF camera device 10 are disposed side by side in the up-down direction. In this case, the misalignment between the irradiation region 210 and the light-receiving region 220 is likely to increase in the up-down direction. For this reason, with shortening of a length of each of the divided regions 271 to 282 in the up-down direction, the divided regions to be turned off can be finely decided as compared with a case where the length thereof is long. Thus, a ratio of a total area of the divided regions to an area of the target region 211 can be increased.

On the contrary, a case will be described in which the length of the divided region in the right-left direction is shorter than the length thereof in the up-down direction.

FIG. 6B shows an example of a case where the irradiation region 210 of the light emitted from the TOF camera device 10 toward the object 200 is divided into two rows and six columns, and thus is divided into a total of 12 divided regions 291 to 302. In the example of FIG. 6B, the length of the rectangle-shaped divided region in the right-left direction is shorter than the length thereof in the up-down direction. In this case, since all of the divided regions 291 to 302 partially overlap with the light-receiving region 220, there is no divided region included in the target region 211. Therefore, there is no divided region for which the TOF camera device 10 is turned off.

### <Modification Examples 2 and 3>

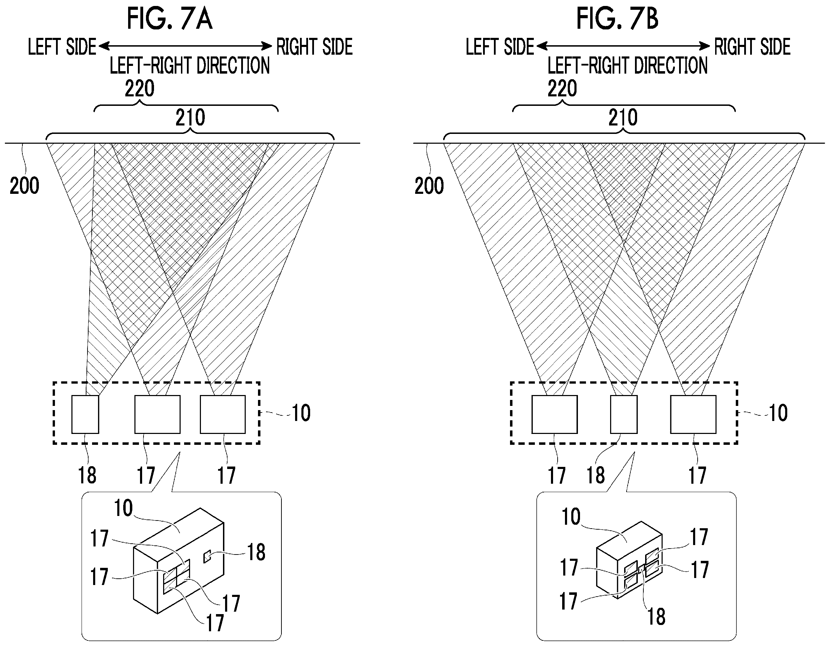

FIGS. 7A and 7B are diagrams showing a specific example of a case where a plurality of light emitting units 17 of the TOF camera device 10 are disposed. A surface of the TOF camera device 10 facing the object 200 (surface on which the light emitting unit 17 and the light receiving unit 18 are disposed) is shown in speech bubbles in FIGS. 7A and 7B.

FIG. 7A shows a specific example of a case where four light emitting units 17 are disposed to be close to each other (Modification Example 2). On the contrary, FIG. 7B shows a specific example of a case where the four light emitting units 17 are disposed to be separated from each other as compared with the example of FIG. 7A (Modification Example 3).

As shown in FIGS. 7A and 7B, in a case where the irradiation region 210 of FIG. 7A and the irradiation region 210 of FIG. 7B are compared with each other, the irradiation region 210 of FIG. 7B is larger than the irradiation region 210 of FIG. 7A since the four light emitting units 17 of FIG. 7B are separated from each other. In this case, a region in which the irradiation region 210 does not overlap with the light-receiving region 220 becomes large, and thus the misalignment between the irradiation region 210 and the light-receiving region 220 becomes large. For this reason, in a case where the plurality of light emitting units 17 are provided, for example, it is preferable that the plurality of light emitting units 17 are disposed to be close to each other, as shown in FIG. 7A.

### <Other Exemplary Embodiments>

The present exemplary embodiments have been described above, but the present invention is not limited to the exemplary embodiments. Further, effects of the exemplary embodiments of the present invention are not limited to the effects disclosed in the exemplary embodiments. For example, all of the configuration of the TOF camera system 1 shown in FIG. 1 and the hardware configuration of the TOF camera device 10 shown in FIG. 2 are merely examples for achieving the object of the present invention, and are not particularly limited.

Further, the functional configuration of the TOF camera device 10 shown in FIG. 3 is also merely an example, and is not particularly limited. As long as the TOF camera system 1 in FIG. 1 is provided with the function with which the above processing can be executed as a whole, a functional configuration to be used to realize the function is not limited to the example in FIG. 3. Further, the specific examples shown in FIGS. 4 to 7 are also merely examples, and are not particularly limited.

Further, in the above exemplary embodiment, for example, the detection unit 113 of the TOF camera device 10 is configured to detect the target region and the divided region, but the present invention is not limited thereto. For example, the user may visually determine the target region and the divided region.

Further, in the above exemplary embodiment, the light with which the divided region included in the target region is irradiated is turned off to suppress the waste of energy, but the light may not necessarily be turned off. For example, an output of the light with which the divided region included in the target region is irradiated may be reduced to suppress the waste of energy.

### (Supplementary Note)

(((1))) An optical device comprising:
   a light emitting unit that has a plurality of light emitting elements to irradiate, with light, each of a plurality of divided regions into which an irradiation region is divided and to emit the light with which an object is irradiated;
   a light receiving unit that has a plurality of light receiving elements to receive reflected light of the light with which the object is irradiated; and
   a light emission control unit that controls, in a region in which a light-receiving region of the reflected light in the object does not overlap with an irradiation region of the light with which the object is irradiated, light emission of the light with which the divided region, which is included in a target region corresponding to the irradiation region, is irradiated.
(((2))) The optical device according to (((1))),
   wherein the light emission control unit controls the light emission of the light with which the divided region, which is included in the target region, is irradiated in a manner different from control of the light emission of the light with which the divided region, which is not included in the target region, is irradiated.
(((3))) The optical device according to (((2))),
   wherein the light emission control unit turns off the light with which the divided region is irradiated, as the control of the light emission.
(((4))) The optical device according to any one of (((1))) to (((3))),
   wherein a shape of the divided region is decided such that a ratio of a total area of the divided regions, which are included in the target region, to an area of the target region is increased.
(((5))) The optical device according to (((4))),
   wherein the shape of the divided region is a rectangle, and the light emitting unit and the light receiving unit are disposed side by side in a direction of a short side of the rectangle.
(((6))) The optical device according to any one of (((1))) to (((5))), further comprising:
   a detection unit that detects the target region,
   wherein the light emission control unit controls the light emission of the light with which the detected target region is irradiated.
(((7))) The optical device according to (((6))),
   wherein the detection unit further detects the divided region included in the detected target region, and
   the light emission control unit controls the light emission of the light with which the detected divided region is irradiated.

According to (((1))), influence of misalignment, which is caused by a position at which the misalignment between the light-receiving region and the irradiation region occurs and the shape of the divided region, can be suppressed.

According to (((2))), since the light emission is controlled for each divided region included in the target region, the influence of the misalignment caused by the shape of the divided region can be suppressed.

According to (((3))), since the light emitted toward the target region can be turned off, waste energy consumption can be suppressed.

According to (((4))), in a case where the area of the divided region included in the target region is increased, an area of the divided region that straddles the target region and the light-receiving region is relatively reduced. Therefore, the influence of the misalignment caused by the shape of the divided region can be suppressed.

According to (((5))), the divided region can be included in the target region without waste.

According to (((6))), there is no need for a person to visually determine the target region. According to (((7))), there is no need for a person to visually determine the divided region.

The foregoing description of the exemplary embodiments of the present invention has been provided for the purposes of illustration and description. It is not intended to be exhaustive or to limit the invention to the precise forms disclosed. Obviously, many modifications and variations will be apparent to practitioners skilled in the art. The embodiments were chosen and described in order to best explain the principles of the invention and its practical applications, thereby enabling others skilled in the art to understand the invention for various embodiments and with the various modifications as are suited to the particular use contemplated. It is intended that the scope of the invention be defined by the following claims and their equivalents.

### Brief Description of the Reference Symbols

1: TOF camera system
10: TOF camera device
11: control unit
17: light emitting unit
18: light receiving unit
30: user terminal
90: network
111: acquisition unit
112: management unit
113: detection unit
114: light emission control unit
115: transmission control unit
200: object
210: irradiation region
220: light-receiving region
211: target region
231, 232, 233, 234, 235, 236, 237, 238, 239, 240, 241, 242, 251, 252, 253, 254, 255, 256, 257, 258, 259, 260, 261, 262, 271, 272, 273, 274, 275, 276, 277, 278, 279, 280, 281, 282, 291, 292, 293, 294, 295, 296, 297, 298, 299, 300, 301, 302, ...: divided region

## Claims

1. An optical device comprising:
a light emitting unit that has a plurality of light emitting elements to irradiate, with light, each of a plurality of divided regions into which an irradiation region is divided and to emit the light with which an object is irradiated;
a light receiving unit that has a plurality of light receiving elements to receive reflected light of the light with which the object is irradiated; and
a light emission control unit that controls, in a region in which a light-receiving region of the reflected light in the object does not overlap with an irradiation region of the light with which the object is irradiated, light emission of the light with which the divided region, which is included in a target region corresponding to the irradiation region, is irradiated.

2. The optical device according to claim 1,
wherein the light emission control unit controls the light emission of the light with which the divided region, which is included in the target region, is irradiated in a manner different from control of the light emission of the light with which the divided region, which is not included in the target region, is irradiated.

3. The optical device according to claim 2,
wherein the light emission control unit turns off the light with which the divided region is irradiated, as the control of the light emission.

4. The optical device according to any one of claims 1 to 3,
wherein a shape of the divided region is decided such that a ratio of a total area of the divided regions, which are included in the target region, to an area of the target region is increased.

5. The optical device according to claim 4,
wherein the shape of the divided region is a rectangle, and the light emitting unit and the light receiving unit are disposed side by side in a direction of a short side of the rectangle.

6. The optical device according to any one of claims 1 to 5, further comprising:
a detection unit that detects the target region,
wherein the light emission control unit controls the light emission of the light with which the detected target region is irradiated.

7. The optical device according to claim 6,
wherein the detection unit further detects the divided region included in the detected target region, and
the light emission control unit controls the light emission of the light with which the detected divided region is irradiated.
